# EUROPEAN PATENT SPECIFICATION

(11) **EP 2 293 330 B1**
(45) Date of publication and mention of the grant of the patent: **07.06.2017**
(21) Application number: 09169770.6
(22) Date of filing: 08.09.2009
(51) Int. Cl.: H01L 23/50, H01L 23/528

(54) **On-chip power switches implementation.**
On-chip-Leistungsschalterimplementierung
Application de commutateurs de puissance sur des puces

(43) Date of publication of application: 09.03.2011
(73) Proprietor: OCT Circuit Technologies International Limited, Dublin 18 (IE)
(72) Inventor: Mrcarica, Zeljko, 8049 Zürich (CH); Burigana, Paolo, 8045 Zürich (CH); Van Hoof, Roger, 8912 Obfelden (CH)
(74) Representative: Grünecker Patent- und Rechtsanwälte PartG mbB

(56) References cited:
- US-A1- 2005 010 887
- US-A1- 2007 007 642
- US-A1- 2007 023 878
- US-B1- 6 461 895

## Description

The invention relates to integrated circuits, especially low-power integrated circuit designs, and more particularly to the implementation of on-chip power switches.

In deep-submicron integrated circuit technology, transistor leakage represents an important problem, especially in mobile applications, in which the battery life is determined to the high extent by the stand-by power, i.e. by the integrated circuit consumption when it is not active.

One of the methods to reduce leakage power consists in switching off the power supply of inactive parts of the system. For example, US Patent Application US2007/0023878 discloses an IC with on-die power-gating circuit. With a high level of integration, it is usually not possible to switch off the whole integrated circuit as some parts of such complex circuits are always active. However, one or more blocks, or subcircuits, of a system-on-chip can often be switched off.

In one design, we can therefore have one or more switchable domains which can be switched off during standby time, and an always-on domain that is also supplied during the system standby time.

However, on one hand, the stronger requests for longer lasting batteries and the increasing complexity of the systems in mobile applications are leading to a reduction of the area of always-on domains when compared to other parts of the system-on-chip. On the other hand, the number of switchable domains in a system-on-chip and the surface occupied by such a switchable domain are both increasing.

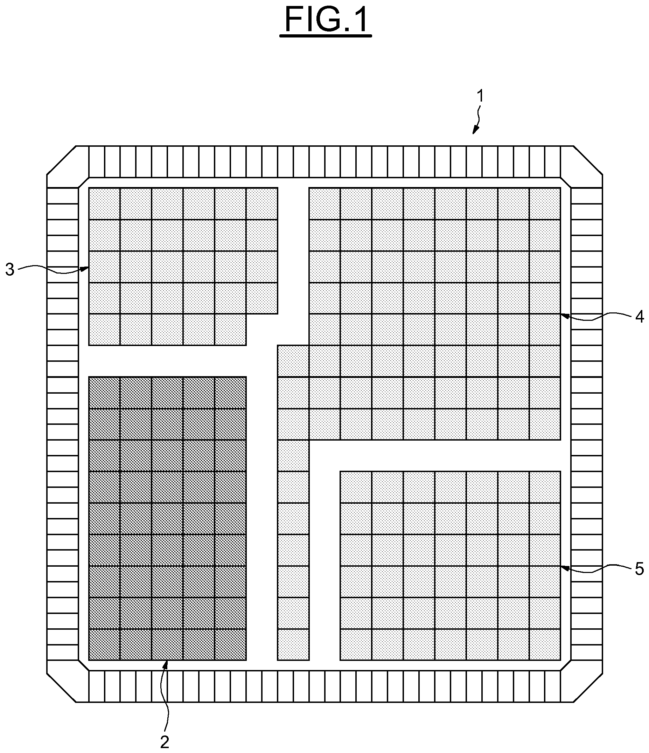

Thus, one can have a situation as depicted in Figure 1 which illustrates schematically a system-on-a-chip comprising an integrated circuit 1 including several different power domains. The integrated circuit 1 comprises an always-on domain 2 and three switchable domains 3, 4 and 5, not all surrounding or neighbouring the always-on domain 2.

Therefore, such a configuration brings up the problem of how to efficiently implement power switches for switchable power domains in such systems.

It is assumed, in this kind of configuration, that switches are inserted on the power line, and that the ground line is common. This assumption is the common approach, simpler to implement as the ground in modern semiconductor technologies usually is the p-type substrate. One can, however, switch the ground supply line instead, or both the power supply and the ground supply line.

For switching the power supply line, PMOS transistors are usually used as they are more efficient when pulling-up. Indeed, the gate of PMOS transistor does not need to be on a voltage higher than the power line as an NMOS transistor would. Alternatively, one can still use NMOS transistors or the combination of both types.

In all known designs using on-chip switches, the switchable domains usually correspond to islands located in an always-on domain. In such a configuration, power supply meshes of the always-on domain can be separated from a switchable domain by power switches. In this case, in order to minimize the voltage drop, it is convenient to use many parallel power switches, and to place them around the switchable domain. Such an approach is suitable if the always-on domain is neighbouring or surrounding every switchable domain.

However, it is not appropriate for a circuit such as the one illustrated in Figure 1 for which such a solution cannot be efficiently implemented as certain switchable domains are not neighbouring the always-on domain.

Another known way of implementing switchable power domains is to create a continuous always-on domain power mesh in higher metal layers, also over the switchable domain, and to insert the switches in the lower level of metals. Such a technique consists in placing the power switches in the row of standard cells. In this approach, the metal used for the power supply rail in the standard cell row is interrupted in the special power switch cell that fits by its height into the standard cell row. This approach is useful for switchable domains that consist of standard cells only.

However, it cannot be used to switch off the supply of an already integrated chiplet or a subsystem including such integrated chiplet and/or memories.

There are also variations of the solutions depicted above.

The approaches described above are supported by the modern integrated circuit design flows. The dimensions of the switches are determined by the allowed voltage drop when they are turned on, and by their leakage current when they are turned off.

All known existing solutions are supposing that the always-on domain is the default domain in the circuit and the switchable domains are islands in it.

According to an embodiment, a solution is provided to solve the problems mentioned above on the on-chip switch implementations when big parts of designs are to be switched on and off. It proposes in particular a new switch organization which reduces leakage currents when parts of the designs are in stand-by, for any always-on domain / switchable domain floor plan organization chosen.

Thus, according to an aspect an electronic component is proposed comprising an integrated circuit with its associated package, said integrated circuit including supply means, at least one switchable domain, and at least one controllable switching device coupled between said at least one switchable domain and said supply means.

According to a general feature of this aspect, said at least one controllable switching device is located within the integrated circuit and is electrically connected between said at least one switchable domain and said supply means by electrical connecting means having a first part located within said integrated circuit, a second part located between said integrated circuit and said package and a third part extending within said package.

Said supply means may be either power supply means or ground supply means.

The supply means may be installed in an always-on domain. Said at least one controllable switching device being electrically connected between said at least one switchable domain and said supply means by electrical connecting means having a third part extending within the package enables to realize power switching when the default always-on domain comprising the supply means is not available in the circuit or is not neighbouring the switchable domains, giving more flexibility in floor planning of the integrated circuit design. The electronic component may comprise a switching domain within the integrated circuit including the at least one controllable switching device, and eventually all the switching devices.

Centralizing the controllable switching devices in a common domain creates less routing congestion compared to switches that are placed around the switchable domains. The electronic component may comprise a control unit included in an always-on domain able to command the at least one controllable switching device. The electronic component may comprise an external control unit which is electrically coupled to the integrated circuit but not mounted on the integrated circuit. According to the invention as defined in claim 1, the electronic component comprises electrical connecting means, wherein the third part of the electrical connecting means comprises a low ohmic routing, for example metallic lines, between a controllable switching device and a power mesh of a switchable domain.

Having low-ohmic connections in the package enables to place the at least one controllable switching device far away from the switchable domains, giving therefore more flexibility in floor planning of the integrated circuit design.

By-passing of at least one controllable switching device is possible as the switchable domain is directly accessible through the package or on the wafer (unpackaged devices). This is advantageous for testing the integrated circuit.

This by-pass saves the test time, since the switch does not need to be initialized by the control unit before the subsystem is tested. The switchable subsystem on a system-on-chip can be therefore designed, verified and tested separately. The second part of the electrical connecting means may comprise connecting bumps or pillars, and the electronic component may be realized in flip-chip packaging technology.

In flip-chip packaging, the die is flipped and mechanically and electrically connected to the package substrate over the bumps or pillars. The bumps are distributed as an array over the die surface. Thus, the input/output pads are not necessarily aligned along the die edge as in wirebonding design, but can also be placed in a central area of the die. This advantage is especially beneficial for core power supplies as one can supply the power directly to the power mesh thus lowering the voltage drop.

One can also note that having the switches on-chip reduces the bill of materials compared to the case when external switching devices are used. The second part of the electrical collecting means may comprise bonding wires.

Other advantages and characteristics of the invention will appear at the examination of the detailed description of two realizations of the invention, being in no way limiting, and of the appended drawings on which:
- figure 1, already described, illustrates a system-on-chip with several power domains;
- figure 2 is a diagrammatic cross-section of an example of electronic component comprising on-chip power switches using flip-chip technology;
- figure 3 is another representation of implementation of on-chip power switches using flip-chip technology;
- figure 4 illustrates an example of implementation of controllable switching devices using a wire bonded package.

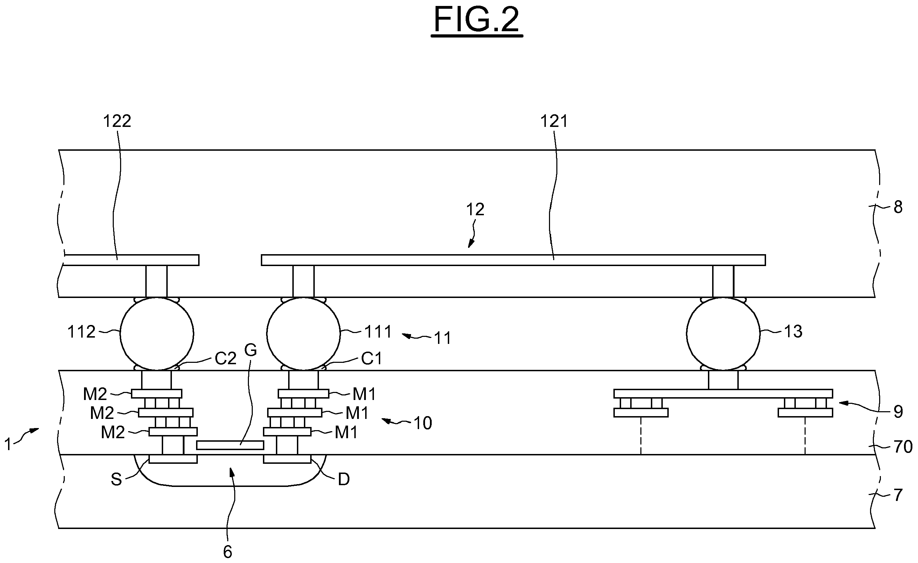

Figure 2 presents a diagrammatic cross-section of an electronic component comprising a controllable switching device 6 and using flip-chip technology.

On this figure, the system-on-chip has been represented with a silicon substrate 7 at the base of the integrated circuit 1 on which electronic elements are built and concealed in a dielectric material 70, and a package substrate 8 mounted above the integrated circuit in flip-chip technology. Also represented on the figure is a part of a switchable domain 9 built in the integrated circuit 1.

In this illustrated embodiment, the integrated circuit 1 comprises a controllable switching device 6 comprising a transistor having a gate G, a source S, and a drain D.

The controllable switching device 6 is coupled between supply means of an always-on domain and the switchable domain 9 by electrical connecting means.

The electrical connecting means comprise a first part 10 located within the integrated circuit. The first part 10 comprises, in this example, of a first plurality of metal lines M1 and vias coupled to the drain D of the transistor and a second plurality of metal lines M2 and vias coupled to the source of the transistor. A first connection point C1 on the upper surface is coupled to the first plurality of metal lines M1 and a second connection point C2 on the upper surface is coupled to the second plurality of metal lines M2.

The electrical connecting means also comprise a second part 11 located between said integrated circuit 1 and said package 8. In this illustrated embodiment, the second part comprises conductive bumps 111 and 112, usually used in flip chip technology. A first conductive bump 111 is connected to the first connection point C1, and a second conductive bump is connected to the second connection point C2.

The electrical connecting means finally comprises a third part 12 extending within the package 8, including, in this illustrated embodiment, a first electrical routing 121 coupled to the first conductive bump 111 on one end and to the switchable domain 9 via a third conductive bump 13 on its other end, and of a second electrical routing 122 coupled to the second conductive bump 112 on one end and to supply means of the always on domain on its other end.

Thus, depending on the state of the transistor of the controllable switching device 6 the switchable domain 9 is either switched-off or switched-on, being supplied in power by the supply means of the always-on domain in this last case.

One can note that the dimensions of the objects on this figure are not in relation. For instance, the transistor used as a switch would be significantly smaller compared to other features, and the metal routings 121 and 122 in the package would be in reality much thicker than the metal layers M1 and M2 on the chip.

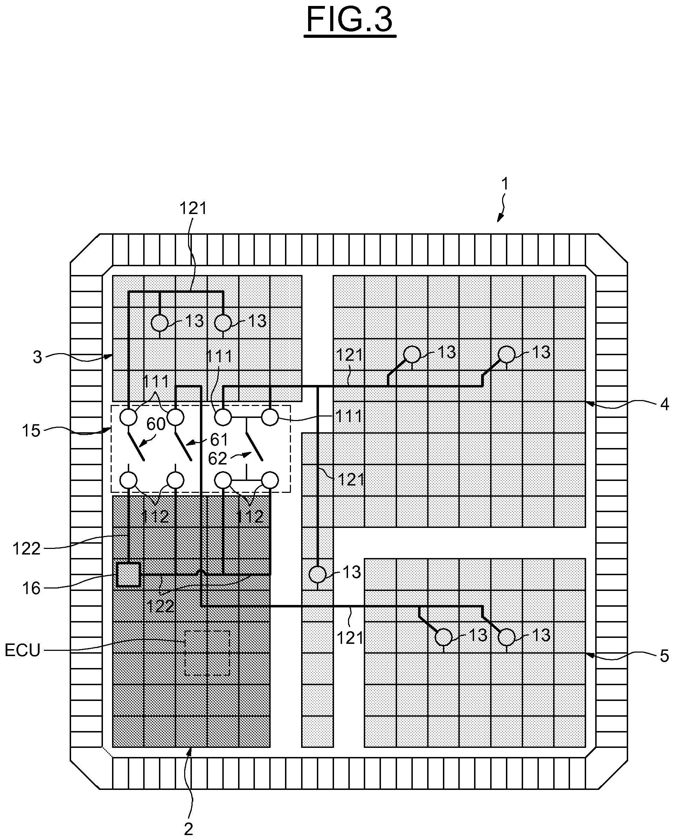

Figure 3 schematically illustrates an implementation of controllable switching devices 60, 61 and 62 on an integrated circuit 1 using flip-chip technology. The integrated circuit 1 comprises an always on-domain 2 and three switchable domains 3, 4 and 5, not all surrounding or neighbouring the always-on domain 2.

In this figure, the controllable switching devices 60, 61 and 62, also called power switches, are gathered in a switching domain 15 causing less routing congestion compared to power switches positioned around the switchable domains.

Each of the controllable switching devices 60, 61 and 62 comprises a transistor as switching element, as illustrated in figure 2.

The controllable switching devices 60, 61 and 62 are coupled on one end to supply means 16 included in the always-on domain 2 thanks to electrical routings 122 extending through the package 8. The supply means 16 can also be external to the integrated circuit 1 and connected to the always-on domain 2. In this illustrated embodiment, the conductive bumps 112 neighbouring the always-on domain 2 are coupled to the supply means 16.

On their other end the controllable switching devices 60, 61 and 62 are connected to switchable domains via conductive bumps 111.

The first controllable switching device 60 enables to supply power to a first switchable domain 3 when its transistor is conductive via a conductive bump 111 coupled to two conductive bumps 13 thanks to an electrical routing 121 extending through the package 8.

The second controllable switching device 61 enables to supply power to a second switchable domain 4 when its transistor is conductive via a conductive bump 111 coupled to two conductive bumps 13 thanks to an electrical routing 121 extending through the package 8.

The third controllable switching device 62 enables to supply power to a third switchable domain 5 when its transistor is conductive via a conductive bump 111 coupled to three conductive bumps 13 thanks to an electrical routing 121 extending through the package 8.

The controllable switching devices 60, 61 and 62 are controlled by a control unit ECU, coupled to each of them.

With this configuration the controllable switching devices are integrated in the design without having both ends of each controllable switching device directly connected to the other circuitry on the integrated circuit 1.

The same can be realized in a system using different packaging techniques and coupling techniques. The packaging technologies can be similar to flip-chip, as for example fan-out package, or different as wire bonded package.

This approach allows bypassing the controllable switching devices 60, 61 and 62 for testing the integrated circuit, the test including wafer-level test as the switchable domains are directly accessible over the bumps or bonding wires. Test time can therefore be saved as the switch does not need to be initialized by the control unit before the subsystem is tested.

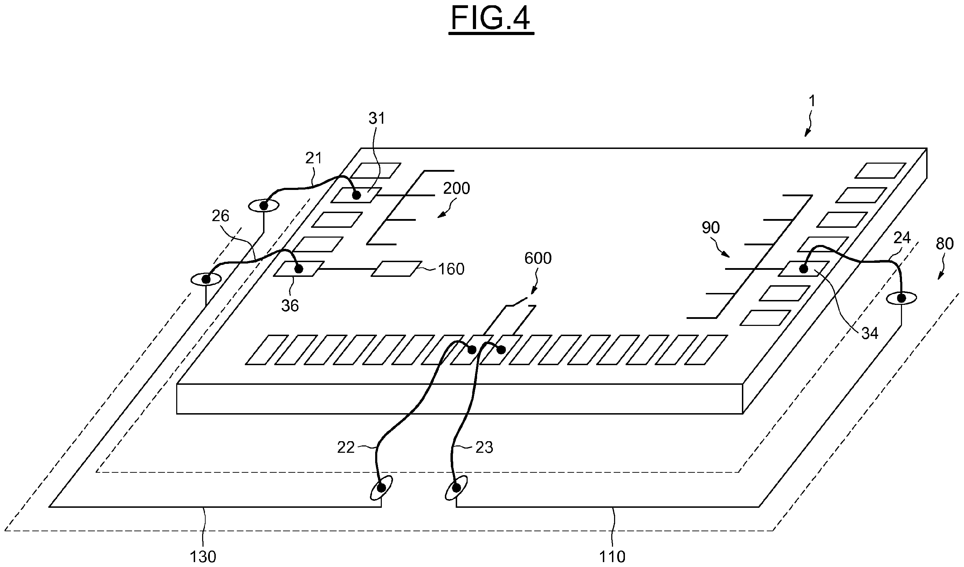

Figure 4 illustrates an implementation of controllable switching devices using a wire bonded package. In this kind of system, the switched power is routed from the switch to the package using bonding wires, in the package substrate using package metallization, and then to the switched domain on the same die using bonding wires. It is even possible to wire bond directly from one pad to another, skipping the package substrate.

In this illustrated embodiment, the integrated circuit 1 comprises here an always-on domain 200 and a switchable domain 90. The always-on domain may be coupled to a first electrical routing 130 realized in a package substrate 80 via a bonding wire 21 coupled to the first electrical routing 130 at one end and to an electrical connection 31 of the always-on domain. The electrical routing 130 may also be connected to supply means via an electrical connexion 36 coupled to another electrical connexion 160 directly coupled to the supply means and to a bonding wire 26 coupled to the electrical routing 130. The supply means may be on the integrated circuit or external. There can also be external to the integrated circuit, directly connected to the electrical routing 130 of the package substrate 80.

In the wire-bonded configuration, the package substrate 80 is not above the integrated circuit 1 but is bellow it and extending on the sides.

The first electrical routing 130 may be coupled at its other end to a controllable switching device 600 via a bonding wire 22. This controllable switching device 600 is controlled by a control unit that may be part of the always-on domain 200, but not represented on this figure.

At its other end, the controllable switching device 600 is coupled to a second electrical routing 110 also realized in the package substrate 80. The coupling is done via a bonding wire 23. At its other end, the second electrical routing 110 is coupled to the switchable domain 90 thanks to a bonding wire 24 coupled to directly to the second electrical routing and to an electrical connection 34 of the switchable domain 90.

Thus, the switchable domain 90 can be supplied in power through the controllable switching device 600, which does not need to be located close to the switchable domain in the floorplan of the integrated circuit. Depending on the state of the controllable switching device, the power supply of the switchable domain 90 can either be switched on or off.

The package routing is shown in this illustrated embodiment as being on the surface of the package substrate 80. It is, however, done over the one or more metal layers buried in the package substrate.

According to particular embodiment, the invention enables to implement controllable switching devices, or power switches, on the integrated circuit as one or more blocks which are not necessarily located close to the switchable domain itself. The controllable switching devices can be laid out more efficiently, resulting in smaller integrated circuit area.

The connections between the at least one switchable device and the controllable switching device are made through the package substrate thanks to electrical routings.

Depending on the technology used, the connections between the electrical routings of the package substrate and the domains of the integrated circuit can be made, for example, either by bonding wires, or by conductive bumps.

The technical advantage is bigger in a flip-chip packaging or in similar technologies than in wire bonded packaging, as shorter power routes are possible.

Moreover, this invention enables power switching of switchable domains when the default always-on domain is not available in the circuit, or is not neighbouring the switchable domains. The design is simplified since the power domains are designed without power switches, and the centralization of the controllable switching devices creates less routing congestion.

The low-ohmic connections in the package enable to position the switches far away from the switched domains offering an increased flexibility in floor planning of the integrated circuit design.

Furthermore, switching on a controllable switching device for a given power domain does not create a voltage drop in the neighbouring domains inducing therefore a simpler switching control, and a faster powering-up.

The controllable switching devices can be bypassed since the switchable domains are directly accessible over the bumps or the bonding wires. Test time can therefore be saved as the switch does not need to be initialized by the control unit before the subsystem is tested.

Finally, having the controllable switching devices on-chip allows reducing costs of materials compared to the case when external switching devices are used.

## Claims

1. Electronic component comprising an integrated circuit (1) and its associated package (8), said integrated circuit (1) including supply means (16), at least one switchable domain (9), and at least one controllable switching device (6) coupled between said at least one switchable domain (9) and said supply means (16), wherein said at least one controllable switching device (6) is located within the integrated circuit (1) and is electrically connected between said at least one switchable domain (9) and said supply means (16) by electrical connecting means having a first part (10) located within said integrated circuit (1), a second part (11) located between said integrated circuit (1) and said package (8) **characterized in that** said electrical connecting means further comprise a third part (12) extending within said package (8), the third part (12) of the at least one controllable switching device (6) comprising a low-ohmic routing between the second part (11) of the electrical connecting means and a power mesh of a switchable domain (9).

2. Electronic component according to claim 1, further comprising a switching domain (15) within the integrating circuit (1) including the at least one controllable switching device (6).

3. Electronic component according to claims 1 or 2, further comprising a control unit included in an always-on domain (2) able to control the at least one controllable switching device (6).

4. Electronic component according to any one of claims 1 to 3, **characterized in that** the second part (11) of the electrical connecting means comprises a connecting bumps (111, 112).

5. Electronic component according to any one of claims 1 to 4, **characterized in that** it is realized in flip-chip packaging technology.

6. Electronic component according to claims 1 to 3, **characterized in that** the second part (11) of the electrical connecting means comprises bonding wires (22, 23).

## Patentansprüche

1. Elektronisches Bauelement, umfassend einen integrierten Schaltkreis (1) und sein zugehöriges Package (8), wobei der integrierte Schaltkreis (1) eine Versorgungseinrichtung (16), wenigstens einen schaltbaren Bereich (9) und wenigstens eine steuerbare Schaltvorrichtung (6) umfasst, die zwischen den wenigstens einen schaltbaren Bereich (9) und die Versorgungseinrichtung (16) geschaltet ist, wobei die wenigstens eine steuerbare Schaltvorrichtung (6) innerhalb des integrierten Schaltkreises (1) angeordnet ist und elektrisch zwischen den wenigstens einen schaltbaren Bereich (9) und die Versorgungseinrichtung (16) durch elektrische Verbindungseinrichtungen geschaltet ist, die einen ersten Teil (10), der sich innerhalb des integrierten Schaltkreises befindet, und einen zweiten Teil (11) haben, der sich zwischen dem integrierten Schaltkreis (1) und dem Package (8) befindet,
**dadurch gekennzeichnet, dass** die elektrischen Verbindungseinrichtungen weiterhin einen dritten Teil (12) umfassen, der sich innerhalb des Packages (8) erstreckt, wobei der dritte Teil (12) der wenigstens einen steuerbaren Schaltvorrichtung (6) eine niederohmige Leitung zwischen dem zweiten Teil (11) der elektrischen Verbindungseinrichtungen und einem Leistungsnetz eines schaltbaren Bereiches (9) umfasst.

2. Elektronisches Bauelement nach Anspruch 1, weiterhin umfassend einen Schaltbereich (15) innerhalb des integrierten Schaltkreises (1), der die wenigstens eine steuerbare Schaltvorrichtung (6) umfasst.

3. Elektronisches Bauelement nach Anspruch 1 oder 2, weiterhin umfassend eine Steuereinheit, die in einem Dauereinschaltbereich (2) enthalten ist, der die wenigstens eine steuerbare Schaltvorrichtung (6) steuern kann.

4. Elektronisches Bauelement nach einem der Ansprüche 1 bis 3, **dadurch gekennzeichnet, dass** der zweite Teil (11) der elektrischen Verbindungseinrichtungen Verbindungserhebungen (111, 112) umfasst.

5. Elektronisches Bauelement nach einem der Ansprüche 1 bis 4, **dadurch gekennzeichnet, dass** es in der Flip-Chip-Packaging-Technik realisiert ist.

6. Elektronisches Bauelement nach Anspruch 1 bis 3, **dadurch gekennzeichnet, dass** der zweite Teil (11) der elektrischen Verbindungseinrichtungen Bonding-Drähte (22, 23) umfasst.

## Revendications

1. Composant électronique comprenant un circuit intégré (1) et son boîtier associé (8), ledit circuit intégré (1) comprenant un moyen d'alimentation (16), au moins un domaine commutable (9) et au moins un dispositif de commutation réglable (6) couplé entre ledit ou lesdits domaines commutables (9) et ledit moyen d'alimentation (16), dans lequel
ledit ou lesdits dispositifs de commutation réglables (6) sont situés dans le circuit intégré (1) et sont raccordés électriquement entre ledit ou lesdits domaines commutables (9) et ledit moyen d'alimentation (16) par des moyens de raccordement électrique ayant une première partie (10) située dans ledit circuit intégré (1), une deuxième partie (11) située entre ledit circuit intégré (1) et ledit boîtier (8), **caractérisé en ce que** lesdits moyen de raccordement électrique comprennent une troisième partie (12) s'étendant dans ledit boîtier (8), la troisième partie (12) du ou des dispositifs de commutation réglables (6) comprenant un routage faiblement ohmique entre la deuxième partie (11) des moyens de raccordement électrique et un maillage électrique d'un domaine commutable (9).

2. Composant électronique selon la revendication 1, comprenant en outre un domaine de commutation (15) dans le circuit intégré (1) comprenant le ou les dispositifs de commutation réglables (6).

3. Composant électronique selon les revendications 1 ou 2, comprenant en outre une unité de commande incluse dans un domaine toujours mis sous tension (2) qui peut commander le ou les dispositifs de commutation réglables (6).

4. Composant électronique selon l'une quelconque des revendications 1 à 3, **caractérisé en ce que** la deuxième partie (11) des moyens de raccordement électrique comprend des bosses de raccordement (111, 112).

5. Composant électronique selon l'une quelconque des revendications 1 à 4, **caractérisé en ce qu'**il est réalisé dans une technologie de conditionnement de la puce retournée.

6. Composant électronique selon l'une quelconque des revendications 1 à 3, **caractérisé en ce que** la deuxième partie (11) des moyens de raccordement électrique comprend des fils de connexion (22, 23).
